(19) **Europäisches Patentamt**

**European Patent Office**

**Office européen des brevets**

(11) Veröffentlichungsnummer : **0 166 968**
**B1**

(12) **EUROPÄISCHE PATENTSCHRIFT**

(45) Veröffentlichungstag der Patentschrift :
27.07.88

(21) Anmeldenummer : 85106644.9

(22) Anmeldetag : 30.05.85

(51) Int. Cl.⁴ : **H 01 L 23/48**

(54) **Halbleiter-Modul für eine schnelle Schaltanordnung.**

(30) Priorität : 01.06.84 DE 3420535

(43) Veröffentlichungstag der Anmeldung :
08.01.86 Patentblatt 86/02

(45) Bekanntmachung des Hinweises auf die Patenterteilung : 27.07.88 Patentblatt 88/30

(84) Benannte Vertragsstaaten :
DE FR GB IT

(56) Entgegenhaltungen :
DE-A- 3 201 296
FR-A- 2 535 898
GB-A- 2 015 291
LEISTUNGSTRANSISTOREN IM SCHALTBETRIEB,
1976, Seiten 162, 163, Thomson-CSF, München; B.
MAURICE: "Anwendung von schnellen Gleichrichtern"
PATENT ABSTRACTS OF JAPAN, Band 8, Nr. 44 (E-
229)[1481], 25. Februar 1984; & JP - A - 58 200 562
(MITSUBISHI DENKI K.K.) 22.11.1983
PATENT ABSTRACTS OF JAPAN, Band 8, Nr. 149 (E-
255)[1586], 12. Juli 1984; & JP - A - 59 55044 (MITSU-
BISHI DENKI K.K.) 29.03.1984

(73) Patentinhaber : Anton Piller GmbH & Co. KG
Abgunst 24
D-3360 Osterode/Harz (DE)

(72) Erfinder : Sachs, Klaus, Dipl.-Ing.
Quellenweg 26
D-3360 Osterode/Harz (DE)

(74) Vertreter : Gralfs, Harro, Dipl.-Ing.
Am Bürgerpark 8
D-3300 Braunschweig (DE)

**Beschreibung**

Die Erfindung bezieht sich auf ein Halbleiter-Modul für eine schnelle Schaltanordnung mit einem aktiven Halbleiterschaltelement und einer Freilaufdiode, die in unmittelbarer Nachbarschaft angeordnet sind, mit einem gemeinsamen Lastanschluß von Halbleiterschaltelement und Freilaufdiode derart, daß das Halbleiterschaltelement und die Freilaufdiode bezogen auf den gemeinsamen Lastanschluß gleichsinnig von Strom aus einer Gleichspannungsquelle durchflossen werden, die an die jeweils anderen Anschlüsse von Halbleiterschaltelement und Freilaufdiode angeschlossen ist. (Siehe, Leistungstransistoren im Schaltbetrieb, 1976, Seiten 162, 163 ; Thomson-CSF, München ; B. Maurice « Anwendung von schnellen Gleichrichtern ».)

Halbleiter-Modulen dieser Art (GB 2 015 291) werden beispielsweise zur Erzeugung einer variablen Gleichspannung aus einer festen Spannungsquelle als sogenannte « Chopper » eingesetzt. Das Halbleiterschaltelement liegt hier in Reihe mit der Last und wird periodisch ein- und ausgeschaltet. Die Höhe der Ausgangsspannung ergibt sich bei konstanter Eingangsspannung aus dem Verhältnis von Einschaltzeit zu Ausschaltzeit.

Bei induktiver Last wird während der Ausschaltzeit der durch die Induktivität getriebene Laststrom durch die Freilaufdiode geleitet. Der Strom fließt dabei in dem durch die Last und die Freilaufdiode gebildeten Stromkreis. Der durch die gespeicherte magnetische Energie getriebene Strom klingt mit der Zeitkonstanten L/R ab.

Der Strom fließt bei einer derartigen Schaltung während der Einschaltzeit in der Leiterschleife, die durch die Spannungsquelle, die Last und das Halbleiterschaltelement gebildet wird, und wechselt in der Ausschaltzeit in die Leiterschleife über, die durch die Last und die Freilaufdiode gebildet wird. Da beide Leiterschleifen Induktivitäten darstellen, treten beim Ausschaltvorgang Überspannungen auf, die besonders bei schnellen Schaltern gefährlich hoch sind und die Halbleiterschaltelemente gefährden können.

Als Schutz der Halbleiterelemente gegen Überspannungen ist eine Vielzahl von sogenannten Snubber-Schaltungen bekannt (DE-OS 32 01 296), die die in der parasitären Schleifeninduktivität gespeicherte Energie umsetzen. Dies führt zu Verlusten und zu zusätzlicher parasitärer Induktivität.

Es ist weiter bekannt, in die erste Leiterschleife parallel zu der reinen Schaltung aus Halbleiterschaltelement und Last einen Glättungs- oder Stützkondensator zu schalten, von dem die in der Schleifeninduktivität gespeicherte Energie fast verlustlos aufgenommen und während der Einschaltzeit an die Last abgegeben wird.

Bekannt ist es weiter, bei einer Halbleiter-Schalteranordnung mit einer Mehrzahl von Halbleiterschaltelementen, diese parallel an übereinanderliegenden Leiterplatten anzuschließen, die durch eine Isolierschicht getrennt sind. Die Leiterplatten werden dabei gegensinnig von Strom durchflossen, so daß sich die parasitären Leiterinduktivitäten verringern (DE-OS 32 01 296).

Überspannungsprobleme, die mit den bekannten Mitteln nicht mehr lösbar sind, treten auf, wenn für das Halbleiterschaltelement extrem kurze Schaltzeiten, beispielsweise Schaltzeiten in der Größenordnung von 100 ns verlangt werden bei großen Schaltströmen, beispielsweise in der Größenordnung von 100 A. Schaltzeiten von 100 ns liegen um eine Größenordnung niedriger als die bisher üblichen Schaltzeiten in der Größenordnung von 1 µs.

Aufgabe der Erfindung ist es, ein Halbleiter-Modul für eine Schaltanordnung für extrem kurze Schaltzeiten bei hohen Schaltfrequenzen zu schaffen, bei welchem ohne zusätzliche Schaltungsanordnungen das Auftreten von Überspannungen vermieden wird.

Diese Aufgabe wird ausgehend von einem Halbleiter-Modul der gattungsgemäßen Art dadurch gelöst, daß die jeweils anderen Anschlüsse von Halbleiterschaltelement und Freilaufdiode jeweils mit einer von zwei durch eine Isolierschicht getrennten Leiterschichten verbunden sind, die in unmittelbarer Nachbarschaft von Halbleiterschaltelement und Freilaufdiode angeordnet sind und vom Laststrom gleichsinnig durchflossen werden.

Zweckmäßige Ausgestaltungen der Erfindung sind Gegenstand der Unteransprüche.

Die Erfindung ist in der Zeichnung in Ausführungsbeispielen veranschaulicht und im nachstehenden im einzelnen anhand der Zeichnung beschrieben. In dieser zeigen :

Fig. 1   eine bekannte Chopper-Schaltung.

Fig. 2   die gleiche Schaltung in einer erfindungsgemäßen Ausbildung.

Fig. 3   in Seitenansicht schematisch die Ausbildung eines Transistorschalters gemäß der Erfindung.

Fig. 4   in Draufsicht ein Detail des Schalters nach Fig. 3, und zwar den Anschluß für einen Stützkondensator.

Fig. 5   schematisch einen Schnitt längs der Linie V-V in Fig. 3.

Fig. 6   einen Schnitt längs der Linie VI-VI in Fig. 3.

Fig. 7   in Draufsicht eine Leiterausbildung für eine Schaltanordnung nach Fig. 3.

Fig. 8   in Seitenansicht ein Halbleiter-Modul.

Fig. 9   eine Draufsicht auf das Mehrfach-Halbleiter-Modul nach Fig. 8.

Fig. 10   eine bekannte Wechselrichterschaltung.

Fig. 11   eine Wechselrichterschaltung gemäß der Erfindung.

Fig. 12   eine weitere Ausgestaltung der Wechselrichterausbildung nach Fig. 11.

Fig. 13  eine Ausbildung des Mehrfach-Moduls für einen Wechselrichter nach Fig. 11 oder 12.

Fig. 14  eine Anordnung der Halbleiterschaltelemente und der Dioden in einem Mehrfach-Modul für einen Wechselrichter nach Fig. 11 oder 12.

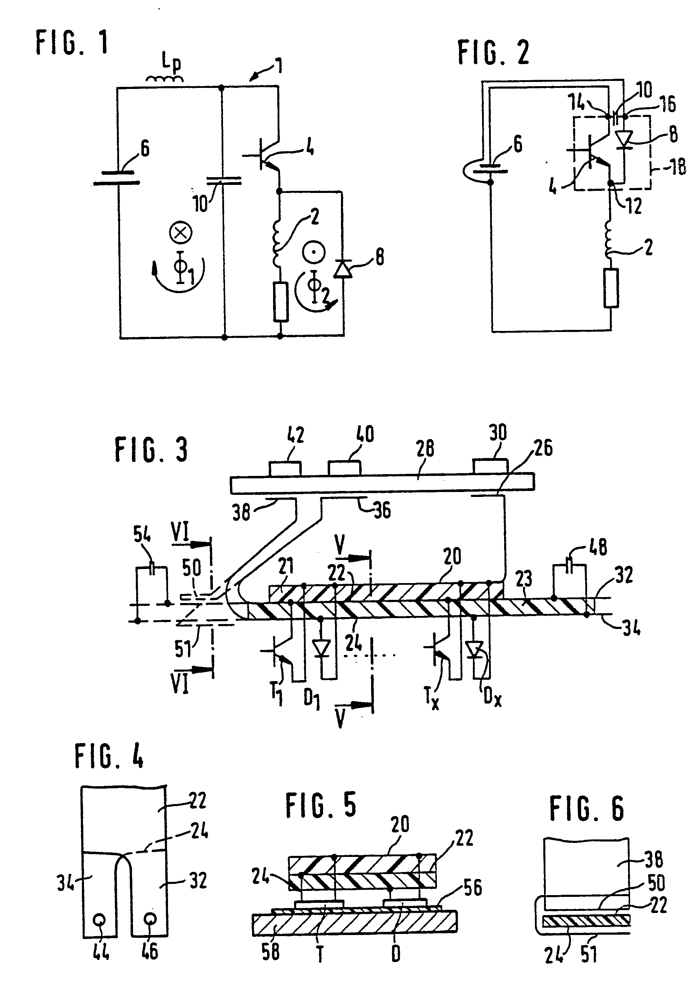

Der Schaltkreis nach Fig. 1 weist eine induktive Last 2 auf, die in Reihe mit einem Schalttransistor 4 angeordnet ist, über den die Last periodisch aus einer Spannungsquelle 6 mit Strom versorgt wird. Parallel zur Last 2 ist eine Freilaufdiode 8 angeordnet. Die Freilaufdiode ist im wesentlichen für die gleiche Leistung ausgelegt wie der Transistor und im nachstehenden kurz als Diode bezeichnet. Bei durchgeschaltetem Transistor 4 tritt ein Fluß $\Phi_1$ auf, der die Leiterschleifenebene gebildet aus dem Transistor 4, der Last 2 und der Stromquelle 6 nach unten verläßt, wie durch den Pfeil angedeutet. Dieser Kreis hat eine Schleifeninduktivität $L_p$. Wenn der Transistor 4 sperrt, wird durch die Induktivität der Last 2 ein Fluß $\Phi_2$ erzeugt, der aus der Leiterschleifenebene gebildet aus der Last 2 und der Diode 8 nach oben austritt, wie durch Pfeil angedeutet. Beim Ausschalten des Transistors 4 wird durch den ersten Leiterkreis durch die Schleifeninduktivität ein Strom getrieben, der über den Transistor 4 eine Spannung $U_s$ erzeugt. Diese Spannung ergibt sich aus der Formel

$$U_s = L \cdot \frac{di}{dt} \, .$$

Erfahrungsgemäß liegt die induktive Komponente des Netzes plus Zuleitungsinduktivität plus Verdrahtungsinduktivitäten in der Größenordnung von etwa 25 μH bis 100 μH.

Beim Abschalten eines Stromes von 5 A in 1 μs ergibt sich an einer solchen Induktivität eine Überspannung von

$$U_s = 100 \; (\mu H) \cdot \frac{5 \, (A)}{\mu s} = 500 \; V \, .$$

Diese Spannung, die die zulässige Überspannung eines Transistors überschreitet, wird dadurch begrenzt, daß in dem Leiterkreis 1 ein Stützkondensator 10 parallel zur Last 2 und zum Transistor 4 geschaltet wird. Durch diesen Stützkondensator wird die für den Kommutierungsvorgang wirksame Leiterschleife reduziert auf die durch den Stützkondensator 10, den Transistor 4 und die Last 2 gebildete Schleife. Die im Abschaltkreis vorhandene Induktivität reduziert sich dadurch etwa um eine Größenordnung auf etwa 2.5 μH bis 10 μH. Die zu erwartende Überspannung ist dann unter sonst gleichen Bedingungen 12.5 V bis 50 V.

Die Möglichkeit, den Transistor durch einen solchen Stützkondensator zu schützen, ist begrenzt einmal durch die vom Transistor zu schaltenden Ströme und zum andern durch die Schaltzeit. Schon eine Vergrößerung des zu schaltenden Stroms auf 100 A ergibt unter Zugrundelegung der übrigen Parameter eine Überspannung von max. 1 000 V. Wird bei einer solchen Stromstärke weiter die Schaltzeit um eine Größenordnung auf beispielsweise 100 ns herabgesetzt, ergibt sich eine Überspannung von max. 10 000 V. In beiden Fällen ist es nicht mehr möglich, die Überspannung am Transistor durch einen Stützkondensator in der nach Fig. 1 beschriebenen Art zu begrenzen.

Fig. 2 zeigt eine Schaltung, bei der bei hohen Strömen, beispielsweise in der genannten Größenordnung von 100 A und Schaltzeiten in der Größenordnung von 100 ns, das Entstehen extremer Überspannungen vermieden wird. Bei der Ausführungsform nach Fig. 2 sind im Prinzip die gleichen Leiterkreise vorgesehen, wie bei der Ausführungsform nach Fig. 1. Abweichend sind hier der Transistor 4 und die Diode 8, die bezogen auf den gemeinsamen Anschluß 12 an die Last — Lastpunkt — gleichsinnig vom Strom durchflossen werden, in unmittelbarer Nachbarschaft angebracht, wie durch den gestrichelt dargestellten Rahmen 14 angedeutet. Auf diese Weise tritt eine sehr enge magnetische Kopplung der stromführenden Leiter des Transistors und der Diode 8 auf. Die aus Stromquelle 6, Transistor 4 und Last 2 bestehende Leiterschleife kann jetzt als Bestandteil der Lastinduktivität aufgefaßt werden. Für den Schaltvorgang ist nur noch die Induktivität der aus der Spannungsquelle 6, dem Transistor 4 und der Diode 8 gebildeten Leiterschleife wirksam. Die Induktivität läßt sich noch weiter verringern, wenn der Stützkondensator 10 unmittelbar zwischen die Anschlüsse 14 und 16 des durch den Transistor 4 und die Diode 2 gebildeten Moduls 18 geschaltet wird. Die beiden zur Spannungsquelle 6 führenden Leiter sind, wie in der Zeichnung durch die enge Parallelführung angedeutet, so eng wie möglich aneinanderliegend geführt und damit magnetisch eng gekoppelt. Die wirksamen Induktivitäten können dabei bis in die Größenordnung von 10 nH verringert werden. Damit ergeben sich auch bei den genannten extrem kurzen Schaltzeiten Überspannungen, die in bekannter Weise wiederum durch einen einfachen Stützkondensator begrenzt werden können. Unter Einbezug der Induktivität des Stützkondensators läßt sich eine Gesamtinduktivität von nur etwa 20 nH erreichen und somit für einen in 100 ns zu schaltenden Strom von 100 A die Überspannung auf etwa 20 V begrenzen.

Die engste Parallelführung und magnetische Kopplung ist erreichbar, wenn Transistor und Diode auf einem Chip angeordnet sind. Auf einem Chip können dabei auch mehrere Transistoren und Dioden jeweils nebeneinander angeordnet werden. Eine solche Parallelschaltung ist im allgemeinen erforderlich, wenn hohe Ströme zu schalten sind. Den Forderungen kann aber auch in ausreichendem Maße dadurch Rechnung getragen werden, daß die Transistoren und die Dioden auf eigenen Chips wechselweise nebeneinander auf einer gemeinsamen Grundplatte, die als Wärmesenke dient, angeordnet werden, wobei es auch möglich ist, diskrete Transistoren und Dioden in zwei gesonderten Reihen anzuordnen. Besonders vorteilhaft ist es, wenn die Halbleiterelemente gegen die gemeinsame Grundplatte isoliert aufgebracht werden, was z. B. durch thermisch gut leitende Isolierschichten aus Berylliumoxyd oder Aluminiumoxyd erfolgen kann. Ein extrem niederinduktiver schneller Schalter für induktive Lasten ist in Fig. 3 schematisch dargestellt. Um die Induktivität der Leiter möglichst gering zu halten, sind die Leiter im Bereich der Anschlüsse der Transistoren und Dioden als Schichtung von drei dünnen, durch Isolierschichten getrennte Leiterbahnen ausgebildet. Diese Leiterbahnen sind vorzugsweise streifenförmig und können beispielsweise aus dünnen Kupferblechen bestehen. Die drei in Fig. 3 dargestellten Leiterschichten 20, 22, 24 sind durch die Isolierschichten 21, 23 voneinander getrennt, die in der Zeichnung übertrieben dick dargestellt sind. Diese Isolierschichten sollten so dünn wie möglich ausgebildet sein. Die oberste Leiterschicht 20 ist hier der Lastanschluß. Diese Leiterschicht ist an einem Ende abgewinkelt, wobei der abgewinkelte Abschnitt 26 eine Anschlußfahne bilden kann, die beispielsweise an der Unterseite einer aus Isoliermaterial bestehenden Anschlußtragplatte 28 anliegen kann und durch eine Schraube mit einem oben auf der Platte 28 liegenden Anschlußpol 30 verbunden ist.

Die darunter liegenden Leiterschichten 32 und 34 sind mit der Gleichstrom-Spannungsquelle verbunden. Die beiden Leiter sind an ihrem linken Ende umgebogen und nach oben geführt, wo sie gleichfalls an ihren Enden mit Laschen 36, 38 von unten gegen die Platte 28 anliegen und über Schrauben mit auf der Oberseite der Platte 28 liegenden Polanschlüssen 40, 42 verbunden sind. Die Lastanschlüsse der Transistoren $T_1$-$T_x$ und der Dioden $D_1$-$D_x$, von denen in der Anlage eine entsprechende Anzahl nebeneinander angeordnet sind, sind mit der Leiterschicht 20 verbunden. Die Transistoren sind drain- bzw. kollektorseitig an die Leiterschicht 32 angeschlossen, während die Dioden mit ihrem zweiten Pol an die Leiterschicht 34 angeschlossen sind.

Wie erwähnt, können die einzelnen Leiterschichten 20, 22, 24 aus Blechstreifen bestehen. Zum Anschluß eines Stützkondensators können die beiden Leiterschichten, die an die Spannungsquelle angeschlossen sind, an einem Ende, bei der Ausführungsform beispielsweise am rechten Ende in Form von getrennten Anschlußfahnen 32, 34 weitergeführt sein. Eine solche Ausbildung von Leiterfahnen ist in Fig. 4 in Draufsicht dargestellt. Die Leiterfahnen haben hier beispielsweise eine Breite, die etwas weniger als die halbe Breite der Leiterschichten beträgt. Die nebeneinanderliegenden Anschlußfahnen können in eine Ebene gebogen sein. Sie sind mit Anschlußbohrungen 44, 46 versehen, durch die die Anschlußschrauben eines Stützkondensatorshindurchführbar sind. Auf diese Weise wird der Stützkondensator elektrisch angeschlossen und gleichzeitig mechanisch gehaltert. Ein solcher Stützkondensator 48 sollte möglichst nahe an den freien, d. h. von der Last abgewandten Anschlüssen 32, 34 von Transistoren und Dioden liegen, um zu einer Leiterschleife geringer Induktivität zu kommen. Entsprechende Anschlußfahnen können am gegenüberliegenden Ende vorgesehen sein. Es sind dann die beiden Leiterschichten 22, 24 entsprechend weiterzuführen. Die zum Anschluß 40 führende Anschlußfahne 50 kann dann, wie gestrichelt dargestellt, mit ihrem den Leiterschichten zugewandten Ende auf der Oberseite der Leiterschicht 22 elektrisch leitend befestigt sein. Die Anschlußfahne, die zu dem Anschlußpol 42 führt, kann mit einem die Leiterschichten 22 und 24 seitlich umgreifenden Ansatz versehen sein, der dann elektrisch leitend an der Unterseite der Leiterschicht 24 befestigt sein kann. Auf den so auch links herausgeführten Leiterfahnen kann ein weiterer Stützkondensator 54 angeordnet sein.

Die Anschlußfahnen an den beiden Enden können gleichzeitig auch als Anschlüsse an die Spannungsquelle dienen. In diesem Fall würden die nach oben zu den Anschlußpolen 40 und 42 führenden Anschlußfahnen entfallen.

Wie aus Fig. 5 ersichtlich, sind die Chips mit den Dioden D und mit den Transistoren T auf einer Substratplatte 56 und mit dieser auf einer als Wärmesenke wirkende Metallplatte 58 befestigt. Bei dieser Anordnung liegen eine Mehrzahl von Transistoren in einer Reihe und parallel dazu liegt eine Reihe von Dioden. In Fig. 5 ist weiter schematisch dargestellt, wie die Dioden bzw. Transistoren mit den Leiterschichten 20, 22 und 24 verbunden sind.

Ein Schalter, wie er in Fig. 3 schematisch dargestellt und im vorstehenden beschrieben worden ist, läßt sich so ausbilden, daß er einschließlich der Induktivität eines Stützkondensators eine Gesamtinduktivität von 20 nH und weniger aufweist.

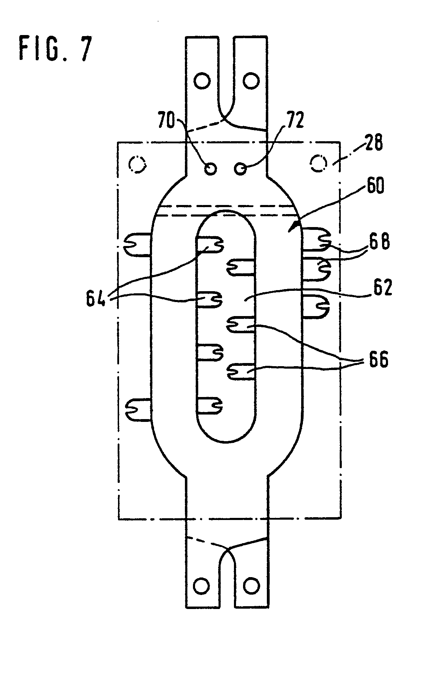

Die Bond-Drähte der Transistoren und Dioden können direkt mit den betreffenden Leiterschichten verbunden werden. Hierzu werden zweckmäßig an den Leiterschichten, also beispielsweise an den die Leiterschichten bildenden Blechstreifen, vorstehende Anschlußelemente vorgesehen, die auch auf beiden Längsseiten angeordnet sein können. Eine weitere Möglichkeit besteht, die Leiterschichten in der Mitte mit einem Längsschlitz zu versehen, wie beispielsweise in Fig. 7 veranschaulicht. Die Leiterschichten 60 sind hier im Bereich der Transistoren und Dioden in der Mitte mit einem länglichen Ausschnitt 62 versehen, in die von zwei der Leiterschichten Anschlußelemente 64, 66 vorstehen. An der dritten Leiterschicht sind Anschlußelemente 68 vorgesehen. Wenn die außen liegenden Anschlußelemente bei einer Anordnung der Chips entsprechend Fig. 5 an der den Lastanschluß bildenden Leiterschicht angeordnet sind, kann es zweckmäßig sein, entsprechende Anschlußfahnen auch in der gegenüberliegenden Seite vorzusehen, so daß für die Bond-Drähte der Si-Chips und der Transistor-Chips jeweils eigene Anschlußelemente zur Verfügung stehen, wodurch die Montage erleichtert werden kann.

Wie in Fig. 7 angedeutet, können in den Leiterschichten Bohrungen 70, 72 vorgesehen sein, durch die Leiter für den Steueranschluß der Transistoren hindurchgeführt werden können.

Grundsätzlich können für Schalter der beschriebenen Art normale schnellwirkende Schalttransistoren vorgesehen sein. Vorzugsweise werden jedoch Feldeffekttransistoren verwendet.

Wie oben beschrieben, können die Leiterschichten aus Blechstreifen mit dazwischen liegenden Isolationen aufgebaut werden. Es ist selbstverständlich auch möglich, die Leiterschichten nach Art einer mehrschichtigen Leiterplatte auszubilden. Wesentlich ist, daß die Leiterschleife mit den Leiterschichten, mit denen die Transistoren bzw. die Dioden mit ihren dem gemeinsamen Anschluß an die Last entgegengesetzten Anschlüssen verbunden sind, dadurch eine möglichst geringe Induktivität hat, daß diese Leiterschichten so eng wie möglich aneinanderliegen.

Die Lage der den Lastanschluß bildenden Leiterplatte 20 ist unkritisch. Diese kann auch in größerem Abstand von den Leiterschichten 22 und 24 liegen und muß nicht unbedingt parallel zu diesen liegen. So kann beispielsweise zwischen der Leiterschichte 22 und dem Lastanschluß eine Leiterplatte mit den Steueranschlüssen für die Transistoren angeordnet sein, über der die Leiterplatte in Abstand gehaltert ist.

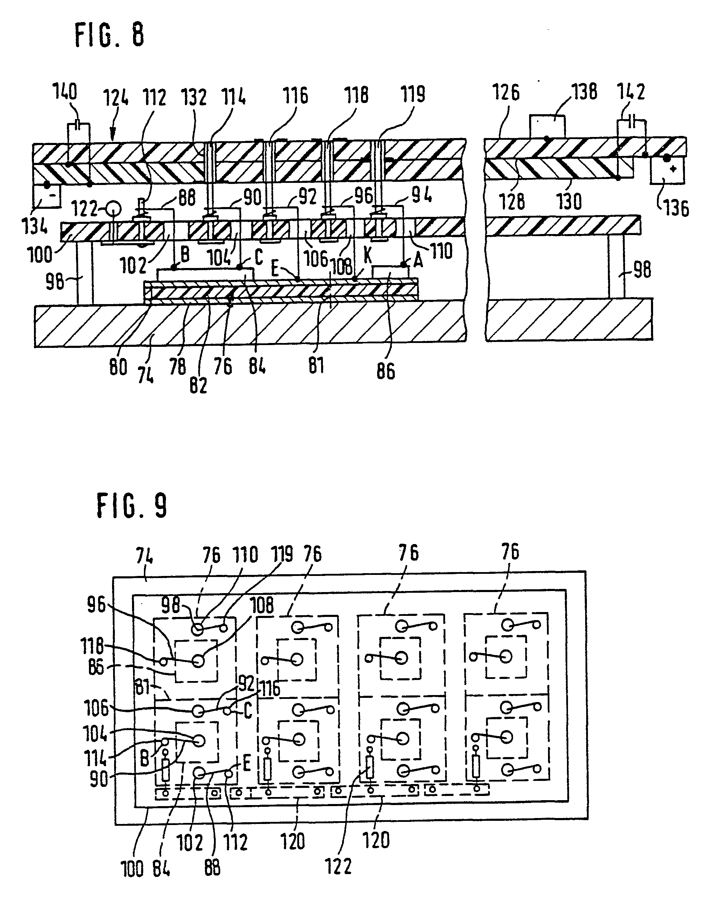

In Fig. 8 und 9 ist schematisch ein Halbleitermodul mit einer Mehrzahl von Transistoren und Dioden dargestellt. Auf einer Kupferplatte 74 als Wärmesenke ist eine Mehrzahl von Chipträgerplatten 76 aufgelötet, die aus einem beidseitig mit einer Kupferschicht 78, 80 kaschierten Platte 82 aus Aluminiumoxid besteht. Die Chipträgerplatte ist mit ihrer Kupferschicht 78 mit der Wärmesenke 74 verlötet. Auf der oberen Kupferschicht sind wenigstens ein Transistorchip 84 und eine Diodenchip 86, vorzugsweise eine Mehrzahl davon, aufgelötet. Eine derartige Mehrzahl von Transistoren und Dioden ist im nachstehenden als Grundmodul bezeichnet.

Die Transistoren und/oder die Dioden eines Grundmoduls können auch auf mehr als einem Chipträger angeordnet werden. Die Kupferschicht 80 ist dabei gemeinsamer Anschlußpunkt für die Transistoren und die Dioden. Die einzelnen Anschlüsse für die Basis B, den Kollektor C und den Emitter des Transistors sind mit Bonddrähten 88, 90, 92 kontaktiert und der zweite Anschluß der Diode 86 mit einem Bonddraht 94.

Sofern freibleiben soll, ob die Diode mit ihrer Kathode oder ihrer Anode mit dem gemeinsamen Lastpunkt verbunden werden soll, kann die Kupferschicht 80 zwischen den Transistorchips 84 und den Diodenchips 86 getrennt sein, wie in Fig. 8 durch den Trennstrich 81 angedeutet. Es ist dann für den Diodenchip 86 ein weiterer Bonddraht 96 vorzusehen.

Da die beispielsweise aus Aluminium bestehenden Bonddrähte nur eine geringe Steifigkeit haben, ist es zweckmäßig, sie mit starren Anschlüssen, beispielsweise Anschlußstiften, zu verbinden, über die dann die Verbindungen zu den Leiterschichten hergestellt werden. Die Anschlüsse, die mit der Kupferschicht 80 zu verbinden sind, können mit dieser verlötet und dann auch starr ausgebildet sein.

In Fig. 8 ist lediglich ein Chipträger mit einem Transistorchip und einem Diodenchip dargestellt. Wie in Fig. 9 dargestellt, werden vorzugsweise mehrere Chipträger verwendet und auf jedem Chipträger sind vorzugsweise mehrere Transistoren und Dioden angeordnet. Weitere Chipträger sind in Fig. 8 als Blöcke gestrichelt dargestellt.

Oberhalb der Chips 84 und 86 ist auf Stützen 98 eine Leiterplatte 100 gehaltert. Diese Leiterplatte ist mit Bohrungen 102 bis 110 versehen, deren Durchmesser groß ist im Verhältnis zum Durchmesser der Bonddrähte 88 bis 96. Neben den Bohrungen 102 bis 110 sind jeweils Anschlußstifte 112, 114, 116, 118 und 119 vorgesehen. Zur Befestigung der Anschlußstifte können an der Unterseite der Leiterplatte 100 diskrete Lötpunkte vorgesehen sein.

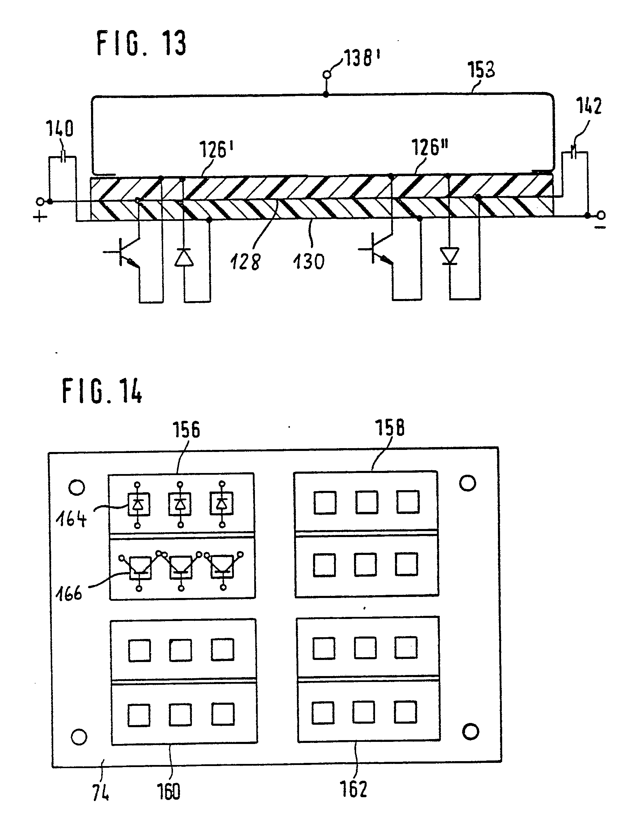

Von den Chipträgern 76 können, wie in Fig. 9 schematisch dargestellt, eine Mehrzahl nebeneinander angeordnet sein, wobei in Fig. 9 die Chipträger 76 jeweils gegenüber der Darstellung in Fig. 8 um 90° gedreht wiedergegeben sind. Eine weitere Anordnung der Chipträger ist in Fig. 14 wiedergegeben, die weiter unten beschrieben wird.

Nach dem Verbinden der Bonddrähte mit den Chips 84 und 86 werden diese senkrecht nach oben ausgerichtet. Es ist dann leicht möglich, auch bei einer großen Zahl von Bonddrähten diese beim Aufsetzen der Leiterplatte 100 durch die relativ großen Bohrungen 102 bis 110 hindurchzuführen. Nach dem Aufsetzen der Leiterplatte 100 werden die Bonddrähte dann mit den Anschlußstiften in bekannter Technik leitend verbunden. Der Anschluß der Bonddrähte an die Anschlußstifte erfolgt zweckmäßig so, daß ein Ausgleich thermisch bedingter Längenänderungen möglich ist. Nachdem die Verbindung zu den Verbindungsstiften hergestellt ist, können die Chips unter der Leiterplatte 100 durch Ausgießen des Zwischenraumes zwischen der Leiterplatte 100 und der Wärmesenkeplatte 74 geschützt werden.

Die Anschlußstifte 112 für die Basis B der Transistoren 84 werden zweckmäßig kürzer ausgebildet als die übrigen Anschlußstifte. An der Unterseite der Leiterplatte 100 können, wie in Fig. 9 angedeutet, Leiterbahnen 120 vorgesehen werden, an die die Basisanschlüsse der Transistoren 84 angeschlossen sind, und zwar vorzugsweise über Vorwiderstände 122, die beim Verlöten der Kontaktstifte gleichzeitig mitverlötet werden. Der Lötpunkt für die Anschlußstifte 112 kann dabei gleichzeitig für den Anschluß des Vorwiderstandes 122 ausgebildet sein. Für Grundmodul wird zweckmäßig eine Leiterbahn vorgesehen, um die Grundmodule wahlweise ansteuern zu können.

Bei der weiter unten zu beschreibenden Schaltung für einen Wechselrichter werden Grundmodule mit Transistoren und Dioden benötigt, bei denen die Dioden an dem gemeinsamen Lastpunkt einmal mit der Anode und zum andern mit der Kathode angeschlossen sind. In diesem Fall wird der Mehrfach-Modul nach Fig. 8 und 9 vorzugsweise mit vier Grundmoduln versehen, und zwar zwei, bei denen die Dioden mit der Anode und zwei, bei denen die Dioden mit der Kathode am Lastpunkt liegen. Sofern auf einem Chipträger eine Mehrzahl von Transistor- und Diodenchips angeordnet ist, kann jeweils auch eine Mehrzahl von Bonddrähten paralleler Pole auf einen Anschlußstift geführt werden.

Ein Mehrfach-Modul nach Fig. 8 und 9 mit einer Mehrzahl von Grundmoduln kann für den jeweiligen Anwendungszweck über eine entsprechend ausgebildete Leiterplatte verschaltet werden. Eine solche Leiterplatte ist, wie es in Fig. 8 und 9 dargestellt ist, zweckmäßig als eine Mehrschichtleiterplatte 124 ausgebildet. Diese Platte ist hier mit drei Dickschichtleiterschichten 126, 128, 130 und mit Bohrungen 132 entsprechend dem Raster der Anschlußstifte 114 bis 118 des Mehrfach-Moduls versehen. Diese Bohrungen 132 sind jeweils durchkontaktiert, und zwar mit Anschluß an die jeweils gewünschte Leiterebene 126, 128 bzw. 130. Bei dem dargestellten Ausführungsbeispiel ist der Leiter in der Leiterebene 126 der Lastanschluß, der Leiter in der Leiterebene 128 der Plus-Pol und der Leiter in der Leiterebene 130 der Minus-Pol. Die Leiter in den Leiterebenen 128, 130 können jeweils an den Enden mit Anschlüssen 134, 136 für den Anschluß der Gleichspannung versehen werden, während der Leiter in der Leiterebene 126 mit einem Lastanschluß 138 versehen ist. An den Enden der Leiterebenen 128, 130 können weiter Anschlüsse für die Stützkondensatoren 140, 142 vorgesehen sein. In den einzelnen Leiterebenen können auch parallele Leiterbahnen ausgebildet sein.

Wie aus dem vorstehenden ersichtlich, lassen sich Mehrfach-Moduln, wie sie im vorstehenden beschrieben sind, in unterschiedlicher Weise verschalten, wobei diese Verschaltung ausschließlich über die Leiterplatte 124 erfolgt. Diese Leiterplatte kann leicht auf die Anschlußstifte des Mehrfach-Moduls aufgesteckt werden. Die Anschlußstifte brauchen dann lediglich in den durchkontaktierten Bohrungen verlötet zu werden. Die Leiterplatte 124 ergibt wie die Leiterausbildung nach den Fig. 3 bis 6 einen extrem induktivitätsarmen Schaltkreis, und zwar auch dann, wenn die den Lastanschluß bildende Leiterschicht der Platte 124 in größerem Abstand von oder in anderer Lage relativ zu den Leiterschichten 128 und 130 angeordnet ist.

Der vorstehend beschriebene Mehrfach-Modul eignet sich in besonderer Weise auch für Brückenschaltungen, wie sie z. B. für Wechselrichter angewendet werden.

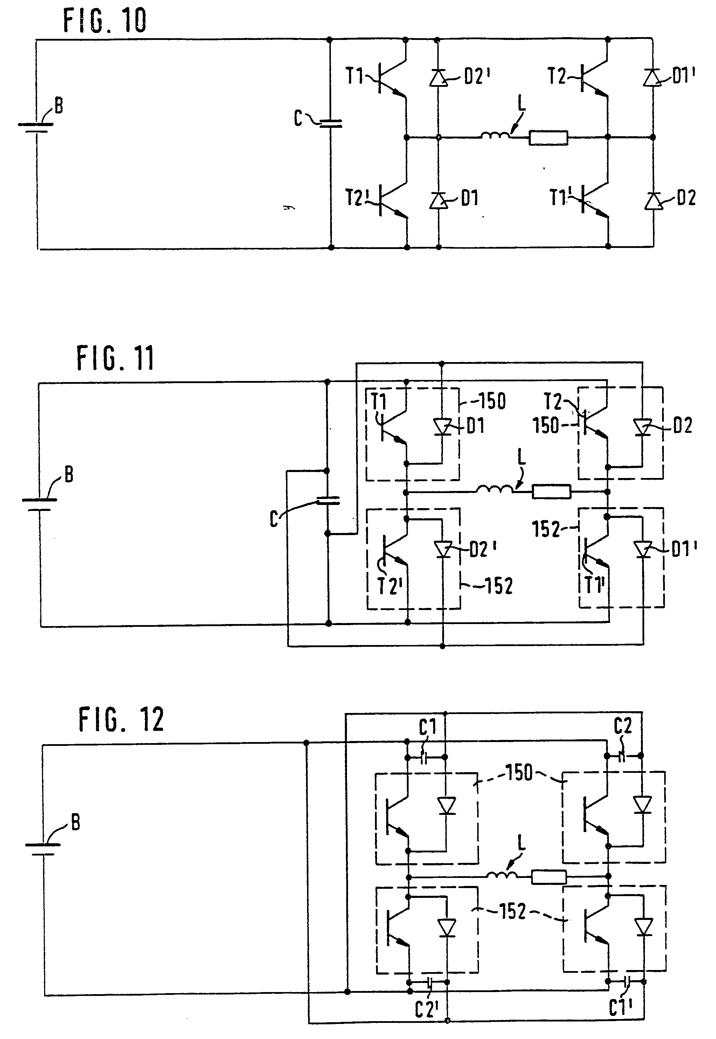

Eine bekannte Wechselrichterschaltung ist in Fig. 10 dargestellt. Sie besteht aus vier Halbleiterschaltelementen, hier Transistoren T1, T1', T2 und T2' sowie aus vier Dioden D1, D1', D2 und D2'. Die Last L ist als ohmsch-induktive Last dargestellt. Sie kann beispielsweise ein Transformator sein. Der Wechselrichter wird aus einer Gleichstromspannungsquelle B gespeist und weist einen zwischen die Speiseleitungen geschalteten Stützkondensator C auf.

Zum Betrieb des Wechselrichters werden über eine nicht dargestellte Steuerung bei Beginn einer Halbwelle z. B. die Transistoren T1 und T1' angesteuert. Der Strom fließt dann von der Spannungsquelle B über Transistor T1 zur Last L und über Transistor T1' zurück zur Spannungsquelle. Nach dem Abschalten der Transistoren T1, T1' wird der Strom durch die in der Induktivität der Last gespeicherte magnetische Energie weiter aufrechterhalten und fließt über die Dioden D1 und D1' zurück zur Spannungsquelle. Gleichzeitig werden die Transistoren T2 und T2' leitend gesteuert, so daß sich der Strom nach seinem Abklingen in der Last umkehrt und dann während der zweiten Halbwelle von der Batterie über die Transistoren T2 und T2' fließt. Nach Ablauf dieser Halbwelle wiederholt sich der gleiche Vorgang. Die Transistoren T2 und T2' werden wieder abgeschaltet, der Strom fließt in gleicher Richtung über die Dioden D2 und D2' zurück zur Spannungsquelle bis nach Einschalten der Transistoren T1 und T1' der Strom wieder über diese fließt. Benachbarte Transistoren und Dioden mit gleichem Last- und Gleichspannungsanschluß werden hier gegensinnig vom Strom durchflossen.

Für die Kommutierung des Laststromes aus den Transistorzweigen in die Diodenzweige ergibt sich das gleiche Problem, wie oben für die Chopper-Schaltung beschrieben. Auch bei der Brückenschaltung nach Fig. 10 durchfließt der Strom jeweils in entgegengesetzter Richtung unterschiedliche, räumliche Leiterschleifen, welche beim Kommutierungsvorgang erheblich die Transistoren gefährdende Span-nungsspitzen im Kommutierungskreis erzeugen können. Durch den Stützkondensator C kann lediglich die Auswirkung der Induktivität der Zuleitungsschleife von der Gleichspannungsquelle bis zum Wechselrichter eliminiert werden.

Bei der erfindungsgemäß ausgebildeten Brückenschaltung nach Fig. 11 sind im Gegensatz zu der Schaltung nach Fig. 10, bei der benachbarte Transistoren und Dioden gegensinnig vom Strom durchflossen sind, die Dioden den Transistoren jeweils so zugeordnet, daß beide gleichsinnig vom Strom durchflossen werden. Bei dieser Anordnung gibt es damit keine Leiterschleifen mehr, die abwechselnd in entgegengesetztem Sinne vom Strom durchflossen werden, wie bei der Ausführungsform nach Fig. 10. Dadurch, daß der Strom jeweils im gleichen Sinne umläuft, wird in Verbindung mit den auch hier, wie oben unter Bezug auf Fig. 1 bis 9 beschrieben, eng benachbart geführten Leitern eine sehr niedrige parasitäre Induktivität der Schaltung erzielt. Die enge Leiterführung braucht hier nur bis zum Stützkondensator C geführt zu werden, wenn dieser niederohmig ist. Damit läßt sich diese Schaltung in besonders zweckmäßiger Weise mit einem Mehrfach-Modul gemäß der Erfindung realisieren.

Eine weitere Verringerung der störenden parasitären Induktivität wird dadurch erreicht, daß der Stützkondensator aufgeteilt wird in vier Teilkondensatoren $C_1$, $C_2$, $C_2'$ und $C_1'$, die jeweils in unmittelbarer Nähe der Grundmodule 150, 152 angeordnet sind. Störend im Sinne der Entstehung einer parasitären Induktivität ist dann lediglich nur noch die Leiterschleife, bestehend aus Transistor, Diode und Kondensator, die durch den oben beschriebenen Aufbau eines Mehrfach-Moduls hinreichend klein gemacht werden kann. Die in den Fig. 11 und 12 dargestellten Grundmoduln 150 bzw. 152 weisen vorzugsweise eine Mehrzahl von parallelen Transistoren und Dioden im Sinne der obigen Ausführungen auf.

Um bei den Schaltungen nach den Fig. 11 und 12 einen Kurzschlußstrom zu vermeiden, der dann auftritt, wenn mit dem Ausschalten des Transistors in dem einen Stromweg gleichzeitig der Transistor im anderen Stromweg eingeschaltet wird, beispielsweise T1 und T1′ ausgeschaltet und gleichzeitig T2 und T2′ ausgeschaltet werden, ist es notwendig, zwischen diesen und den Lastpunkten der Grundmodule 150 und 152 jeweils eine Induktivität vorzusehen. Bei den kurzen Schaltzeiten in der Größenordnung von 100 ns und den großen Stromstärken genügt hier eine Induktivität von wenigen nH. Die Induktivität kann beispielsweise durch eine Leiterschleife gebildet werden, wie sie in Fig. 13 dargestellt ist. In dieser Zeichnung ist das Mehrfach-Modul lediglich durch die beiden unterschiedlichen Grundmodule angedeutet, also durch Module, bei denen die Diode einmal mit ihrer Anode und zum andern mit ihrer Kathode am Lastpunkt liegt. Die Leiterplatte ist hier wieder mit den Leiterschichten 126, 128, 130 schematisch dargestellt. An den Leiterschichten liegt die Gleichspannung an, und zwar mit dem Minus-Pol an der Leiterschicht 130 und dem Plus-Pol an der Leiterschicht 128. Die Leiterschicht 126 für den Lastanschluß ist hier in zwei elektrisch getrennte Leiterabschnitte 126′, 126″ aufgeteilt. Diese beiden Leiterabschnitte 126′ und 126″ sind über eine beispielsweise in Form eines Blechbügels 153 ausgebildete Leiterschleife miteinander verbunden. Die Leiterschleife trägt mittig den Lastanschluß 138′. Die Induktivität einer solchen Leiterschleife reicht aus, um bei den gegebenen Bedingungen Kurzschlüsse beim gleichzeitigen Ein- bzw. Ausschalten der Transistoren in den Grundmoduln zu verhindern. Stützkondensatoren 140, 142 sind hier wiederum zwischen die Leiterschichten 128 und 130 geschaltet.

In Fig. 14 ist eine Schaltanordnung eines Mehrfachmoduls im Prinzip dargestellt. Es sind hier vier Grundmoduln 156 bis 162 dargestellt, die jeweils einen Chipträger aufweisen, wie er oben unter Bezug auf Fig. 8 beschrieben ist. Die Dioden 164 und die Halbleiterschaltelemente 166 sind jeweils auf elektrisch voneinander getrennten Bereichen der oberen leitenden Schicht des Chipträgers aufgelötet. Ungeachtet der Tatsache, daß einer der Anschlußpole die leitende Schicht des Chipträgers ist, sind die einzelnen Pole der Dioden und der Halbleiterschaltelemente jeweils schematisch dargestellt. Sie sind jeweils über Bonddrähte miteinander und/oder den zugehörigen Anschlußstiften verbunden. Wie ohne weiteres ersichtlich, sind alle vier Grundmoduln 156 bis 162 identisch ausgebildet. Sie können über ihre Bonddrähte auch in identischer Weise mit Anschlußstiften verbunden sein.

Die Anzahl der auf jedem der Chipträger angeordneten bzw. dem jeweiligen Grund-Modul zugeordneten Halbleiterschaltelemente 166 ergibt die Strombelastbarkeit jedes einzelnen der Grundmoduln 156 bis 162. Jedes dieser Grundmoduln kann dabei beispielsweise für eine Stromstärke von 30 A ausgelegt sein. Dann läßt sich mit einem Mehrfach-Modul, wie es in Fig. 14 dargestellt ist, bei Parallelschaltung aller Grundmoduln eine Gesamtstromstärke von 120 A schalten. Werden jeweils zwei Grundmoduln parallel geschaltet, läßt sich mit zwei derartigen Mehrfach-Moduln eine Wechselrichterschaltung nach Fig. 11 bzw. 12 nach Art einer Halbbrücke für eine Stromstärke von 60 A realisieren. Mit den vier Grundmoduln läßt sich aber auch eine vollständige Brückenschaltung für 30 A realisieren, wobei dann jeweils die Lastanschlüsse auf vier Abschnitte der Leiterplatte 126 geführt werden, die dann jeweils paarweise über eine induktive Leiterschleife entsprechend Fig. 13 miteinander verbunden sind, deren Mitte dann jeweils einen der Lastanschlußpunkte ergibt. Es braucht dann für die gesamte Schaltung lediglich noch ein einziger Stützkondensator auf dem Halbleiter-Modul vorgesehen zu werden. Zweckmäßig ist es jedoch, zur weiteren Verringerung der parasitären Induktivität zwei Kondensatoren vorzusehen, wie in Fig. 13 dargestellt, die dann wiederum in größter Nähe der Grundmoduln 156, 160 bzw. 158, 162 vorgesehen sein können und dann sowohl während der positiven als auch während der negativen Halbwelle wirksam sind.

Durch die hohe erreichbare Schaltfrequenz von 20 kHz und darüber lassen sich mit einem Wechselrichter der beschriebenen Art in Verbindung mit einer Pulsweitenmodulation in weitgehender Annäherung sinusförmige Ausgangsspannungen erzeugen. Es ist dabei gleichzeitig möglich, durch die hohe Zahl der Einschaltungen während einer Halbwelle Spannungseinbrüche im allgemeinen bereits innerhalb einer Halbwelle zu kompensieren und damit zu einer sinusförmigen Ausgangsspannung hoher Konstanz zu kommen.

Als Halbleiterschalter können schnellschaltende bipolare Transistoren verwendet werden. Besonders zweckmäßig ist die Verwendung von MOS-FET's. Als Schaltelemente können aber auch GTO's Anwendung finden.

**Patentansprüche**

1. Halbleiter-Modul für eine schnelle Schaltanordnung mit einem aktiven Halbleiterschaltelement (4) und einer Freilaufdiode (8), die in unmittelbarer Nachbarschaft angeordnet sind, mit einem gemeinsamen Lastanschluß (12) von Halbleiterschaltelement (4) und Freilaufdiode (8) derart, daß das Halbleiterschaltelement (4) und die Freilaufdiode (8) bezogen auf den gemeinsamen Lastanschluß (12) gleichsinnig von Strom aus einer Gleichspannungsquelle (6) durchflossen werden, die an die jeweils anderen Anschlüsse (14, 16) von Halbleiterschaltelement (14) und Freilaufdiode angeschlossen ist, dadurch gekennzeichnet, daß die jeweils anderen Anschlüsse (14, 16) von Halbleiterschaltelement (4) und Freilaufdiode (8) jeweils mit einer von zwei durch eine Isolierschicht (23) getrennten Leiterschichten (22, 24) verbunden sind, die in unmittelbarer Nachbarschaft von Halbleiterschaltelement (4) und Freilaufdiode (8) angeordnet sind und vom Laststrom gleichsinnig durchflossen werden.

2. Halbleiter-Modul nach Anspruch 1, dadurch gekennzeichnet, daß eine Mehrzahl von Halbleiterschaltelementen $(T_1-T_x)$ und Dioden $(D_1-D_x)$ unmittelbar nebeneinander angeordnet sind, und daß die Leiterschichten (22,24) sich über die Mehrzahl von Halbleiterschaltelementen und Dioden in deren unmittelbarer Nachbarschaft erstrecken.

3. Halbleiter-Modul nach Anspruch 1 oder 2, dadurch gekennzeichnet, daß die Leiterschichten (22,24) aus Blechen bestehen.

4. Halbleiter-Modul nach Anspruch 1 oder 2, dadurch gekennzeichnet, daß eine die beiden Leiterschichten enthaltende mehrschichtige Leiterplatte vorgesehen ist.

5. Halbleiter-Modul nach Anspruch 3 oder 4, dadurch gekennzeichnet, daß die beiden Leiterschichten (22,24), an denen das Gleichspannungspotential anliegt, mit Anschlüssen (32,46 ; 34,44) für einen Stützkondensator versehen sind.

6. Halbleiter-Modul nach Anspruch 3 oder 4, dadurch gekennzeichnet, daß die Leiterschichten im Bereich der nebeneinander liegenden Halbleiterelemente und Dioden in der Mitte mit einem länglichen Ausschnitt (62) versehen sind, in den Anschlußelemente (64,66) wenigstens der mittleren Leiterschicht vorstehen.

7. Halbleiter-Modul nach Anspruch 1, dadurch gekennzeichnet, daß eine Mehrzahl von Halbleiterschaltelementen $(T_1-T_x)$ und/oder Dioden $(D_1-D_x)$ auf wenigstens einer elektrisch isolierenden Substratplatte (56) angeordnet sind.

8. Halbleiter-Modul nach Anspruch 7, dadurch gekennzeichnet, daß die Substratplatte (56) beidseitig mit einer Metallschicht versehen ist und auf einer Wärmesenke (58) angeordnet ist.

9. Halbleiter-Modul nach Anspruch 7 oder 8, dadurch gekennzeichnet, daß eine Mehrzahl von Substratplatten (76) auf einer gemeinsamen Wärmesenke (74) angeordnet sind.

10. Halbleitermodul nach Anspruch 7, dadurch gekennzeichnet, daß starre Verbindungselemente (112-119) vorgesehen sind, mit denen die Bonddrähte (88-94) der Halbleiterschaltelemente (84) und der Dioden (86) leitend verbunden sind.

11. Halbleiter-Modul nach Anspruch 7 oder 8, dadurch gekennzeichnet, daß oberhalb der Halbleiterschaltelemente (84) und der Dioden (86) eine isolierende Kontaktträgerplatte (100) angeordnet ist, in der Anschlußstifte (112-119) befestigt sind.

12. Halbleiter-Modul nach Anspruch 11, dadurch gekennzeichnet, daß für die Bonddrähte (88-94) in der Kontaktträgerplatte (100) Durchführungen (102-110) mit einem im Verhältnis zu den Querschnitten der Bonddrähte großen Querschnitt vorgesehen sind.

13. Halbleiter-Modul nach Anspruch 10 oder 11, dadurch gekennzeichnet, daß die Leiterplatte (124) mit durchkontaktierten Bohrungen (132) zur Aufnahme der starren Verbindungselemente (112-119) versehen ist, wobei die Bohrungen jeweils mit einer der Leiterschichten (126,128,130) leitend verbunden sind.

14. Halbleiter-Modul nach Anspruch 13, dadurch gekennzeichnet, daß bei einem Mehrfachmodul die oberste Leiterschicht (126) den Lastanschluß bildet.

15. Halbleiter-Modul nach Anspruch 7, dadurch gekennzeichnet, daß bei der Hälfte der Kombinationen aus parallel geschalteten Halbleiterschaltelementen und Dioden die Diode an einem ersten Lastpunkt mit der Kathode und bei der anderen Hälfte der Kombinationen die Diode an einem zweiten Lastpunkt mit der Anode angeschlossen ist, und daß die beiden Lastpunkte jeweils über eine Induktivität mit einem gemeinsamen Lastanschluß verbunden sind.

16. Halbleiter-Modul nach Anspruch 15, dadurch gekennzeichnet, daß die Induktivität als Leiterschleife ausgebildet ist, an der symmetrisch der gemeinsame Lastanschluß liegt.

## Claims

1. A semiconductor module, for a high-speed switching arrangement, comprising an active semiconductor switching element (4) and a freewheel diode (8) arranged in direct proximity with each other and having a common load connection (12) for the semiconductor switching element (4) and the freewheel diode (8) such that current flows in the same direction relative to the common load connection (12) through the semiconductor switching element and the freewheel diode from a direct current voltage source (16), which is connected to the respective remaining connections (14,16) of the semiconductor switching element (4) and the freewheel diode, characterised in that each of the remaining connections (14,16) of the semiconductor switching element (4) and the freewheel diode (8) is connected with one of two conductor layers (22,24) separated by an insulating layer (23) arranged in direct proximity to the semiconductor switching element (4) and the freewheel diode (8) and through which the load current flows in the same direction relative to the load.

2. A semiconductor module according to Claim 1, characterised in that a plurality of semiconductor switching elements $(T_1-T_x)$ and diodes $(D_1-D_x)$ are arranged directly alongside each other and that the conductor layers (22,24) extend across the plurality of semiconductor switching elements and diodes in

8

direct proximity thereto.

3. A semiconductor module according to Claim 1, characterised in that the conductor layers (22,24) are formed by sheet metal.

4. A semiconductor module according to Claim 1 or 2, characterised in that there is provided a multilayer circuit board comprising the two conductor layers.

5. A semiconductor module according to Claim 3 or 4, characterised in that the two conductor layers (22,24), to which is connected the direct current voltage source, are provided with connections (32,46 ; 34,44) for a smoothing capacitor.

6. A semiconductor module according to Claim 3 or 4, characterised in that the conductor layers in the region of the adjacent semiconductor elements and diodes are provided in the centre of the layers with an elongated aperture (62), into which connecting elements (64,66) protrude from at least the centre of the conductor layers.

7. A semiconductor module according to Claim 1, characterised in that a plurality of said semiconductor switching elements ($T_1$-$T_x$) or a plurality of said diodes ($D_1$-$D_x$) are arranged on at least one electrically insulating substrate plate (56).

8. A semiconductor module according to Claim 7, characterised in that said substrate plate (56) is provided on both sides with a metallic coating and is arranged on a thermal sink (58).

9. A semiconductor module according to Claim 7 or 8, characterised in that a plurality of said substrate plates (76) are arranged on a common thermal sink (76).

10. A semiconductor module according to Claim 7, characterised in that rigid connecting elements (112-119) are provided, with which bond wires (88-94) of said semiconductor switching elements (84) and said diodes (86) are connected conductively.

11. A semiconductor module according to Claim 7 or 8, characterised in that an insulating contact carrier plate (100) is arranged above said semiconductor switching elements (84) and said diodes (86), in which therminal pins (112-119) are attached.

12. A semiconductor module according to Claim 11, characterised in that openings (102-110) are provided in said contact carrier plate (100) for the bond wires (88-94), said openings having a cross section which is large in comparison to the cross sections of the bond wires.

13. A semiconductor module according to Claim 10 or 11, characterised in that the circuit board (124) is provided with holes (132) for holding rigid connecting elements (112-119), wherein the holes are each connected conductively with one of said conductor layers (126,128,130).

14. A semiconductor module according to Claim 13, characterised in that in a multiple module the upper conductor layer (126) constitutes the load connection.

15. A semiconductor module according to Claim 7, characterised in that in one half of combinaisons of semiconductor switching elements and diodes connected in parallel, the diode is connected to a first-load point by the cathode and in the case of the other half of said combinations, the diode is connected to a second load point by the anode, said two load points each connected via an inductance with a common load connection.

16. A semiconductor module according to Claim 15, characterised in that inductance is designed as a conductor loop in which said common load connection is connected symmetrically.

**Revendications**

1. Module à semi-conducteur pour un agencement de commutation rapide comportant un élément de commutation à semi-conducteur actif (4) et une diode non asservie (8), qui sont disposés à proximité immédiate l'un de l'autre, une connexion de charge commune (12) de l'élément de commutation à semi-conducteur (4) et de la diode non asservie (8) de telle sorte que l'élément de commutation à semi-conducteur (4) et la diode non asservie (8) par rapport à la connexion de charge commune (12) sont parcourus dans le même sens par le courant d'une source de tension continue (6), qui est connectée aux autres connexions respectives (14,16) de l'élément de commutation à semi-conducteur (4) et de la diode non asservie, caractérisé en ce que les autres connexions respectives (14,16) de l'élément de commutation à semi-conducteur (4) et de la diode non asservie (8)1 sont reliées chacune à l'une de deux couches conductrices (22,24) séparées par une couche isolante (23), qui sont disposées à proximité immédiate de l'élément de commutation à semi-conducteur (4) et de la diode non asservie (8) et sont parcourues dans le même sens par le courant de charge.

2. Module à semi-conducteur selon la revendication 1, caractérisé en ce qu'un ensemble d'éléments de commutation à semi-conducteur ($T_1$-$T_x$) et de diodes ($D_1$-$D_x$) sont juxtaposés, et en ce que les couches conductrices (22,24) s'étendent au-dessus de l'ensemble d'éléments de commutation à semi-conducteur et de diodes à proximité immédiate de ceux-ci.

3. Module à semi-conducteur selon la revendication 1 ou 2, caractérisé en ce que les couches conductrices (22,24) sont en tôle.

4. Module à semi-conducteur selon la revendication 1 ou 2, caractérisé en ce qu'une plaque conductrice à couches multiples contenant les deux couches conductrices est prévue.

5. Module à semi-conducteur selon la revendication 3 ou 4, caractérisé en ce que les deux couches conductrices (22,24) auxquelles est appliqué le potentiel de tension continue, sont munies de connexions (32,46 ; 34,44) pour un condensateur d'appoint.

6. Module à semi-conducteur selon la revendication 3 ou 4, caractérisé en ce que les couches conductrices sont munies à proximité des éléments à semi-conducteur et des diodes juxtaposés au milieu d'une échancrure oblongue (62), dans laquelle débordent des éléments de connexion (64,66) au moins de la couche conductrice médiane.

7. Module à semi-conducteur selon la revendication 1, caractérisé en ce qu'un ensemble d'éléments de commutation à semi-conducteur ($T_1$-$T_x$) et/ou de diodes ($D_1$-$D_x$) sont disposés sur au moins une plaque substrat électriquement isolante (56).

8. Module à semi-conducteur selon la revendication 7, caractérisé en ce que la plaque substrat (56) est munie des deux côtés d'une couche métallique et est disposée sur un radiateur thermique (58).

9. Module à semi-conducteur selon la revendication 7 ou 8, caractérisé en ce qu'un ensemble de plaques substrat (76) sont disposées sur un radiateur thermique commun (74).

10. Module à semi-conducteur selon la revendication 7, caractérisé en ce que des éléments de liaison rigides (112-119) sont prévus auxquels les fils de liaison (88-94) des éléments de commutation à semi-conducteur (84) et des diodes (86) sont reliés de façon conductrice.

11. Module à semi-conducteur selon la revendication 7 ou 8, caractérisé en ce qu'au-dessus des éléments de commutation à semi-conducteur (84) et des diodes (86) est disposée une plaque support de contact isolante (100), dans laquelle sont fixées des tiges de connexion (112-119).

12. Module à semi-conducteur selon la revendication 11, caractérisé en ce que pour les fils de liaison (88-94) sont prévues dans la plaque support de contact (100) des traversées (102-110) avec une section importante par rapport aux sections des fils de liaison.

13. Module à semi-conducteur selon la revendication 10 ou 11, caractérisé en ce que la plaque conductrice (124) est munie de perçages (132) à contacts de traversée en vue de la réception des éléments de liaison rigides (112-119), les perçages étant chacun reliés de façon conductrice à l'une des couches conductrices (126,128,130).

14. Module à semi-conducteur selon la revendication 13, caractérisé en ce que, dans le cas d'un module multiple, la couche conductrice supérieure (126) constitue la connexion de charge.

15. Module à semi-conducteur selon la revendication 7, caractérisé en ce que, dans le cas de la moitié des combinaisons d'éléments de commutation à semi-conducteur et de diodes montés en parallèle, la diode est reliée à un premier point de charge par la cathode et dans le cas de l'autre moitié des combinaisons, la diode est reliée à un second point de charge par l'anode, et en ce que les deux points de charge sont reliés chacun par l'intermédiaire d'une inductance à une connexion de charge commune.

16. Module à semi-conducteur selon la revendication 15, caractérisé en ce que l'inductance est réalisée sous la forme d'une boucle conductrice, à laquelle est reliée symétriquement la connexion de charge commune.

FIG. 1

FIG. 2

FIG. 3

FIG. 4

FIG. 5

FIG. 6

FIG. 7

## FIG. 8

## FIG. 9

FIG. 10

FIG. 11

FIG. 12

4

FIG. 13

FIG. 14